# EUROPEAN PATENT SPECIFICATION

(11) **EP 0 388 175 B1**
(45) Date of publication and mention of the grant of the patent: **02.11.1995**
(21) Application number: 90302709.2
(22) Date of filing: 14.03.1990
(51) Int. Cl.: G11C 7/00

(54) **Semiconductor memory device**
Halbleiter-Speichereinrichtung
Dispositif de mémoire à semi-conducteur

(30) Priority: 15.03.1989 JP 62534/89
(43) Date of publication of application: 19.09.1990
(73) Proprietor: Matsushita Electronics Corporation, Kadoma-shi, Osaka 571 (JP)
(72) Inventor: Shikata, Michiharu, Kusatsu-shi, Shiga, 525 (JP)
(74) Representative: Crawford, Andrew Birkby

(56) References cited:
- EP-A- 0 049 988
- EP-A- 0 062 547
- EP-A- 0 129 651
- EP-A- 0 276 852
- US-A- 4 719 602
- US-A- 4 789 966

## Description

The present invention relates to a memory device incorporated in a semiconductor device.

The recent trend of larger capacity, higher performance and superior function of semiconductor memory devices is striking, and the expansion of applicable range seems infinite accordingly. In this background, lately, the uses requiring advanced speed of memories are spreading widely as represented, for example, by the popularity of superhigh-speed large-sized computers and high performance work stations, development of 32-bit personal computers, and applications in video fields. To satisfy such requests for higher speed of large-capacity memory, it is essential to raise the speed by circuit technology, as well as to increase the speed by device technology.

In the aspect of circuit technology, particularly in the dynamic random access memory (DRAM), high speed access mode functions such as page mode, nibble mode and serial mode are proposed and realized. Such increase of speed by circuit technology is supposed to be more important henceforth.

As a conventional semiconductor memory device, hereinafter, an example of DRAM increased in speed by nibble mode function is illustrated below.

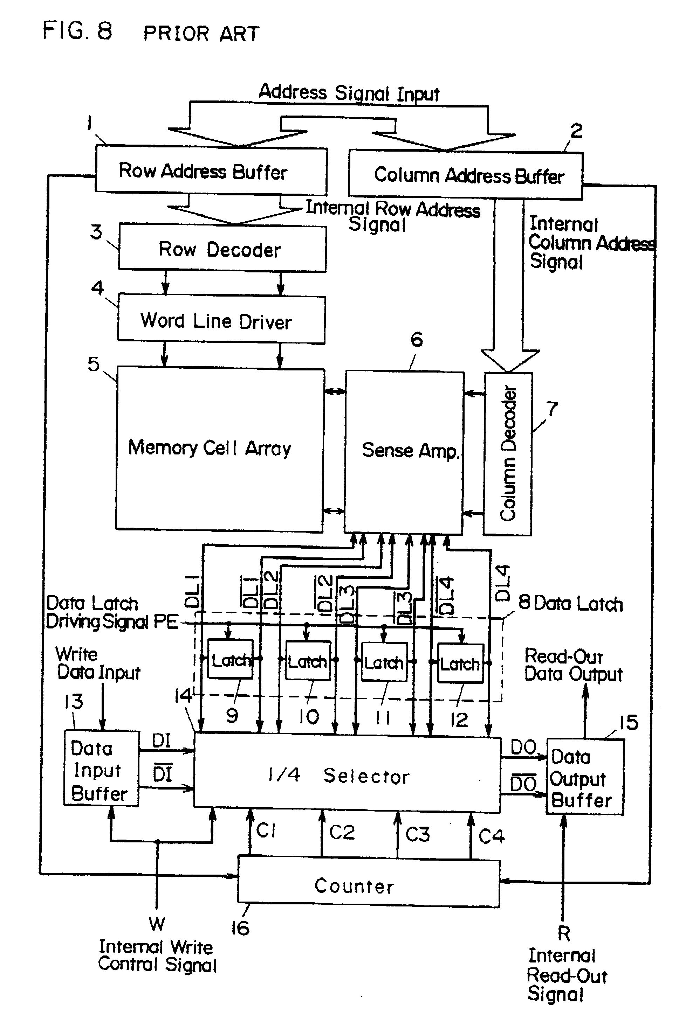

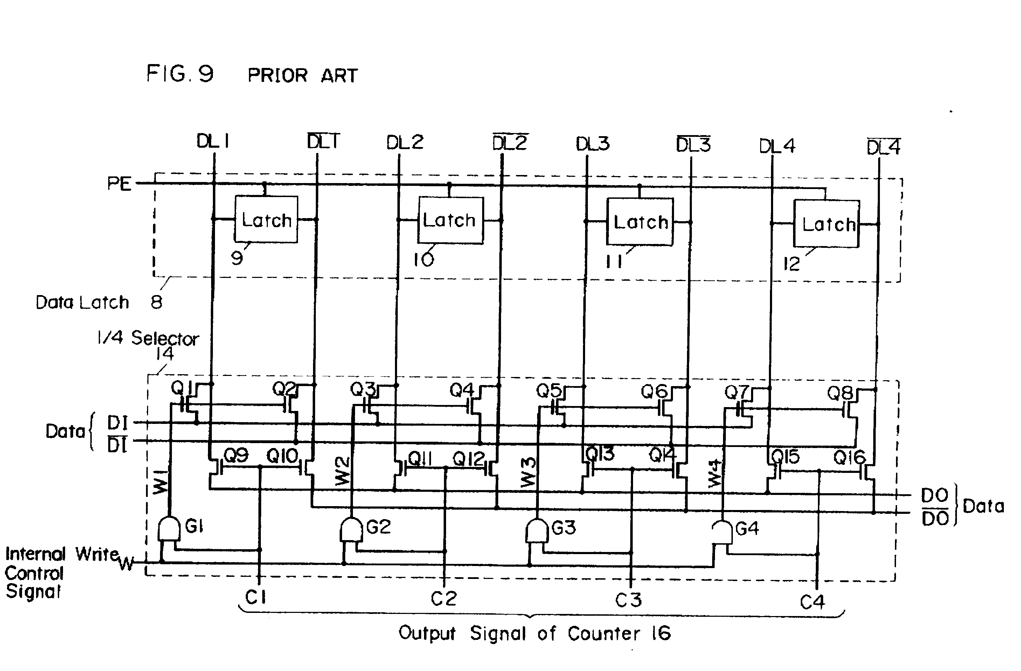

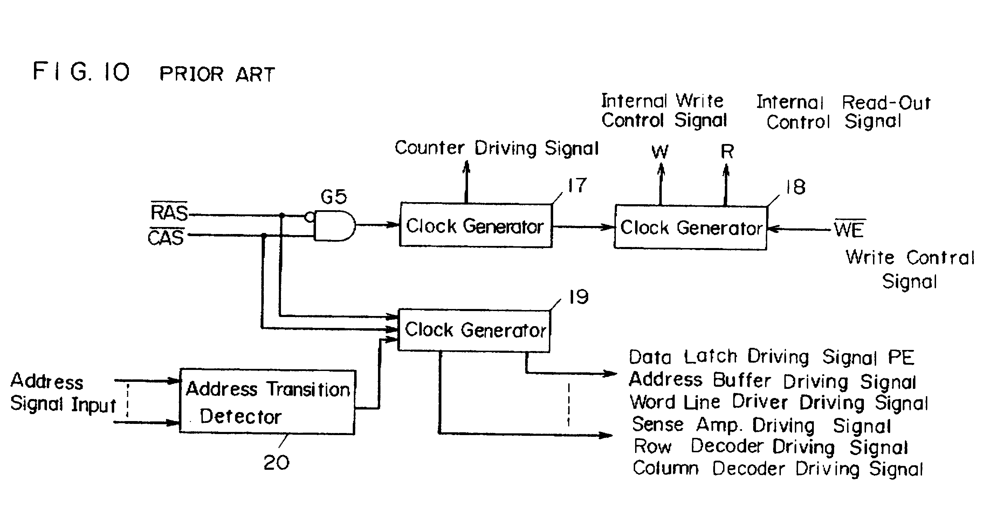

Fig. 8 is a block diagram of a conventional DRAM data reading and writing circuit increased in speed by nibble mode function, Fig. 9 is a detailed circuit diagram of essential portions of the circuit in Fig. 8, Fig. 10 is a block diagram of an internal signal generating circuit for driving the circuits in Fig. 8 and Fig. 9, and Fig. 11 shows voltage waveform diagrams at each node in the circuits in Fig. 8, Fig. 9, and Fig. 10.

In Fig. 8, a row address buffer 1 and a column address buffer 2 generate an internal row address signal and an internal column address signal, depending on the address signal input given to the individual address input terminals. A row decoder 3 and a word line driver 4, responding to the internal row address signal, select one of the plural word lines, and choose the memory cells for the portion of one line from a memory cell array 5 arranged in matrix in the form of row and column. A sense amplifier 6, when reading out the data, amplifies the data being read out from the memory cell connected to the selected word line, and latches it on the bit line which corresponds to a row line. Furthermore, a column decoder 7, in response to the internal column address signal, selects a necessary number of (four, in this example) bit lines out of the plural bit lines, and transfers the data on the selected bit lines to data lines.

Data lines are provided in four pairs. Each data line is composed of two mutually complementary signal lines (when one is at high level, the other is at low level), that is, DL1, D̅L̅1̅; DL2, D̅L̅2̅; D̅L̅3̅, DL3; DL4, D̅L̅4̅. When reading out data, it is a data latch 8 shown in Fig. 8 that is responsible for amplifying the data transferred from the bit line selected by the column decoder 7 to the data line, and latching the data on the data line. This data latch 8 is composed of four latch circuits 9 to 12 corresponding to each pair of the data lines, and these latch circuits 9 to 12 are composed of differential amplifiers, such as dynamic flip-flops. A selector 14 is to select an arbitrary one of the four pairs of data lines, and to exchange data between a data input buffer 13 or data output buffer 15, and the selected data line. A counter 16 is a circuit for giving address information for determining the selection of the data line in the selector 14, and it is mainly composed of a two-bit binary counter for counting by starting from the two-bit address signal corresponding to each bit of the row address and column address of the internal address signal generated by the row address buffer 1 and column address buffer 2.

Fig. 9 shows a detailed circuit composition of the data latch 8 and selector 14 which are particularly closely related with the realization of the nibble mode function in the circuit in Fig. 8.

The selector 14 is composed of MIS transistors Q1 to Q16 and logic gates G1 to G4. Depending on the output signals C1 to C4 and internal write control signal W of the counter 16 shown in Fig. 8, control signals W1 to W4 are generated from the logic gates G1 to G4. On the basis of these control signals W1 to W4, in write mode, the data D1, D̅1̅ generated in the data input buffer 13 in Fig. 8 are transferred to the selected data lines through the transistors Q1 to Q8, and in read mode, the data D0, D̅0̅ are supplied into the data output buffer 15 in Fig. 8, through the transistors Q9 to Q16.

The circuits in Fig. 8 and Fig. 9 are driven by the clock signals generated by the internal clock generating circuit shown in Fig. 10. The internal clock generating circuit in Fig. 10 is composed of clock generators 17 to 19, address transition detector 20, and logic gate G5.

R̅A̅S̅, C̅A̅S̅, W̅E̅ and address signal input are signals given from outside the memory device. R̅A̅S̅ is a reference clock signal for driving the row address buffer 1, row decoder 3, word line driver 4, sense amplifier 6 and data latch 8 shown in Fig. 8. C̅A̅S̅ is a reference clock signal for driving the column address buffer 2, column decoder 7, selector 14, counter 16, data input buffer 13 and data output buffer 15 in the active period of R̅A̅S̅ (while R̅A̅S̅ is at low level as mentioned later). W̅E̅ is a signal for specifying whether the memory device is in read mode or in write mode, and practically, in read mode, by the clock generator 18, the internal reading control signal (clock signal) R is set in active state (high level), and in write mode, the internal writing control signal (clock signal) W is set in active state: (high level).

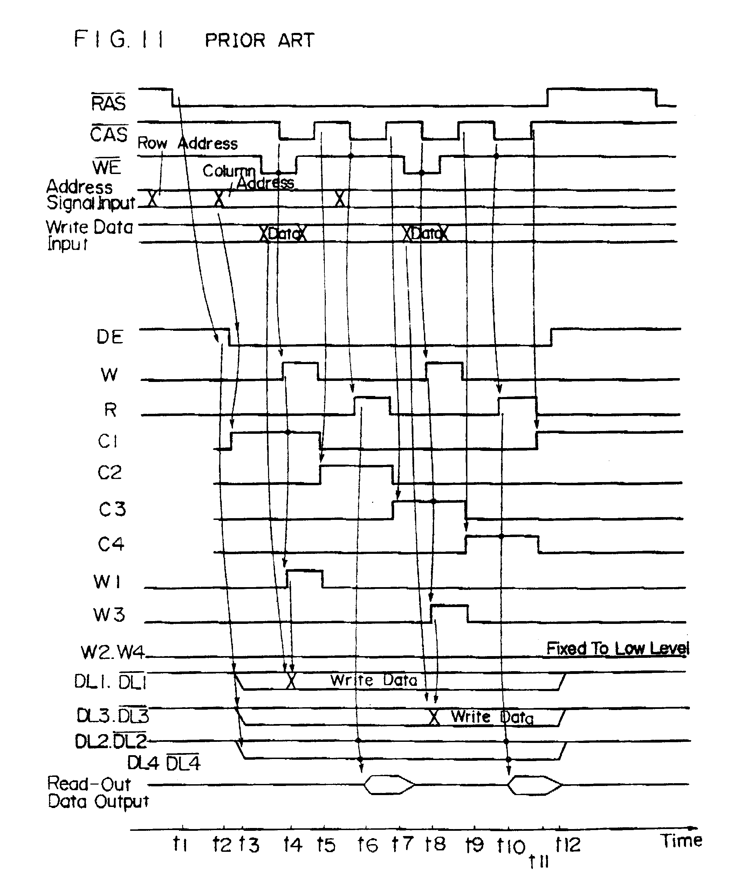

In thus composed semiconductor memory device (DRAM in this conventional example), the operation in the nibble mode is described below while referring to the timing charts in Fig. 11, and the circuit diagrams in Figs. 8, 9, 10.

The nibble mode action is as shown in the timing chart in Fig. 11; that is, by feeding the second reference clock signal C̅A̅S̅ plural times (in other words, by setting C̅A̅S̅ at low level plural times, or four times in Fig. 11, t4 to t5, t6 to t7, t8 to t9, t10 to t11) in the active period of the first reference clock signal R̅A̅S̅, that is, while the R̅A̅S̅ is at low level, the data is read out or written in at high speed at every input of C̅A̅S̅. At this time, the designation of the memory cell subjected to reading or writing at every input of C̅A̅S̅, that is, the designation of row and column addresses is enough only with the designation of the row address by the address input signal in the active state of R̅A̅S̅ [in other words, in the fall of R̅A̅S̅ (time t1)], and the designation of the column address at the time of the first input of C̅A̅S̅ (time t4). At the time of the subsequent C̅A̅S̅ input, without designation of the address by the address signal input, only by the designation of the output signals C1 to C4 of the counter 16 in the memory device, reading and writing is executed sequentially in the four memory cells corresponding to four bits starting with the address specified at the time of the first C̅A̅S̅ input. In particular, as for the reading of data of every input of C̅A̅S̅, the data already latched in the data latch 8 is selected by the counter 16 and selector 14, and it is enough to transfer to the data output buffer 15. Therefore, unlike the ordinary reading, it is not necessary to operate the column decoder or data latch by newly specifying the column address, the speed may be notably higher. In the example in Fig. 11, C̅A̅S̅ input is made four times in the R̅A̅S̅ active period, and first time and third time are data writing, and second time and fourth time are data reading. First, at time t1, R̅A̅S̅ becomes low level, and the row address buffer 1, row decoder 3, sense amplifier 6 and others are put into action, and the data from the memory cells are latched on the bit lines. Next, at time t2, receiving selection of bit lines by the column decoder 7 and data transferred to data lines, the data latch driving signal PE is activated at time t3, and the data latch 8 is actuated. As a result, data is latched in the data lines DL1, D̅L̅1̅ to DL4, D̅L̅4̅. Next, a first C̅A̅S̅ is fed (time t4). At this time, the write control signal W̅E̅ is at low level, that is, the CAS cycle is specified in data write cycle, and therefore, correspondingly, the internal write control signal W is activated, thereby becoming high level. By contrast, at the time of second C̅A̅S̅ input (time t6), since the write control signal W̅E̅ is at high level, this cycle becomes data read cycle, and the internal read control signal R is activated. On the other hand, as for the output signals C1 to C4 of the counter 16 for controlling the quarter selector 14, first, according to the designation of the column address determined at time t2, at the time of the first C̅A̅S̅ input (time t4), the output signal C1 is already in active state (high level), and on every occasion of the subsequent C̅A̅S̅ inputs (time t5, t7, t9), the output signals C2, C3, C4 are sequentially activated. Thus, at the time of the first C̅A̅S̅ input (time t4), the internal write control signal W and output signal C1 are in active state. In consequence, by the action of the logic gate in Fig. 9, the control signal W1 becomes high level, and the transistors Q1, Q2 are made to conduct, and the write data is written in data lines DL1, D̅L̅1̅, and is further written into the memory cells through bit lines. By contrast, at the time of the second CAS input (time t6), the internal write control signal W is in inactive state, while the internal read control signal R and output signal C2 are in active state. As a result, by the internal read control signal R, the data output buffer 15 in Fig. 8 becomes ready to act, and the data D0, D̅0̅ transferred to the data output buffer 15 through transistors Q11, Q12 in Fig. 9 (the data being latched in DL2, D̅L̅2̅ at time t3) are read out at the data output terminal as the read data output. The operation at the time of third and fourth C̅A̅S̅ inputs is basically same as in the first and second inputs, except that the states of C1 to C4 are different, and detailed explanation is omitted.

Thus, in the conventional semiconductor memory device, at the time of the second and subsequent inputs of the reference clock corresponding to C̅A̅S̅, the address signal input is omitted, and the data latched on plural pairs of data lines can be delivered by synchronizing with the reference clock sequentially by the counter 16 and the selector 14 driven by the output signals C1 to C4 of the counter 16, the data reading speed is markedly made higher.

However, regarding the data writing, there is no substantial difference from the operation in the ordinary mode, and high speed operation is not expected by the use of the high speed mode such as nibble mode. In other words, in the conventional circuit composition, writing of data requires transfer of data from the data input buffer 13 to the selector 14, data lines, sense amplifier 6, bit lines, and the memory cell directly. Therefore, all loads such as floating loads parasitizing these circuit blocks must be handled by the data input buffer 13 alone so as to drive all these circuit blocks. Since the loads tend to increase as the memory capacity becomes larger, they are great barriers for increasing the speed of the memory write action. Hence, in order to keep a sufficient writing time, it is required to maintain the Input cycle time of the reference clock in high speed mode over a specific period, and the action time of the memory is regulated by the data write time. Thus, in the semiconductor memory device of the conventional structure, increase of speed was limited by the data write speed.

It is hence a primary object of the invention to solve the problems of the prior art and to present a high speed memory device having a sufficient timing margin.

European Patent Application EP-A-0129651 discloses a dynamic semiconductor memory in which there are provided static memory cells which correspond to dynamic memory cell rows in a dynamic memory cell array. Information is transferred between static memory cells in the static memory cell rows and dynamic memory cells corresponding thereto.

European Patent Application EP-A-0049988 discloses a system for rapidly transferring data between a plurality of successive memory locations of a semiconductor memory and a data output bus characterised in that said system comprises a plurality of N data latches for storing data associated with N successive memory locations which are defined by a plurality of bits of the address input, a corresponding plurality of N serially connected decoders each associated with one of said data latches, each decoder being arranged to be enabled for causing its associated data latch to output its stored data to the data output bus , and each decoder receiving selected bits of the address input such that one of the decoders is initially enabled, in response to said selected bits having a given logic state, for causing its associated data latch to output its stored data to the data output bus , the enabled decoder being arranged to then disable itself and to enable a successive decoder, the latter decoder and each remaining decoder being arranged to disable itself after having been enabled and to enable a successive decoder so as to cause the data latches to output, to the data bus , N successive bits of data in response to a single address input. Rapid writing of data into memory is effected by including N data buffers. Write cycle time is shortened because writing can overlap into three succeeding cycles.

European Patent Application EP-A-0062547 discloses a memory circuit which can perform consecutive write operations at a high speed. The memory circuit comprises a plurality of bus lines, a plurality of memory cell groups associated to the respective bus lines, a plurality of latch circuits coupled to the respective bus lines, and means for sequentially supplying the bus lines with write data, in which the write data are stored in the latch circuits and transferred to selected memory cells of the respective memory cell groups.

European Patent Application EP-A-0276852 discloses a random access memory device for improving controllability and simplifying circuit arrangement, said device comprising a nibble decoder circuit operative to control nibble switching transistors and a read/write control circuit operative to control read/write switching circuits and data amplifier circuits independent from the nibble decoder circuit, and three data bits read out from memory cell arrays are transferred to the same memory cell arrays when a new data bit is written into the memory cell of the other memory cell array directly accessed by an external processor, thereby preventing the data bits from destruction.

### SUMMARY OF THE INVENTION

According to the present invention there is provided a semiconductor memory device comprising:
means for providing a first reference clock signal and a second reference clock signal;
a memory cell array having plural memory cells disposed in an array;
selecting means for selecting a plurality of memory cells from among said plural memory cells of said memory cell array;
a plurality of data lines coupled to said selecting means, each of said plurality of data lines for transmitting write data to and read data from said memory cell array; and
a read data latch means, having a plurality of latch circuits respectively coupled to said plurality of data lines, for temporarily storing read data therein,
characterised in that the device further comprises a write data latch means, having a plurality of buffer circuits respectively coupled to said plurality of data lines, for temporarily storing write data therein in response to a write control signal and in synchronism with the second reference clock signal, during the active period of the first reference signal; and
write history storing means for storing the write history when write data is stored into said write data latch means during the active period of said first reference clock signal;
wherein write data is written in batch into the selected memory cell according to the result of said write history during the inactive period of said first reference clock signal, if there is write history in said write data latch means.

By thus composing, not only the data reading, but also data writing operation may be done at high speed, so that the high speed operation of the memory device may be realized on the whole.

Other objects and features of the invention, as well as the benefits and advantages thereof, will be better understood and appreciated from the following detailed description taken in conjunction with the accompanying drawings.

### BRIEF DESCRIPTION OF THE DRAWINGS

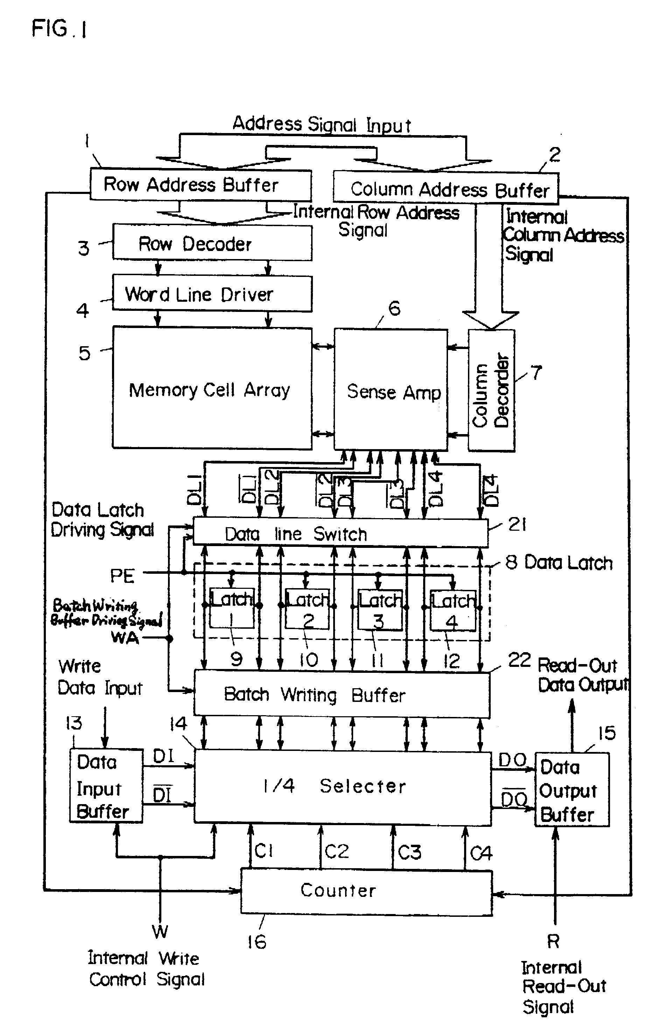

Fig. 1 is a block diagram of data reading and writing circuits of a semiconductor memory device in first embodiment of the invention;

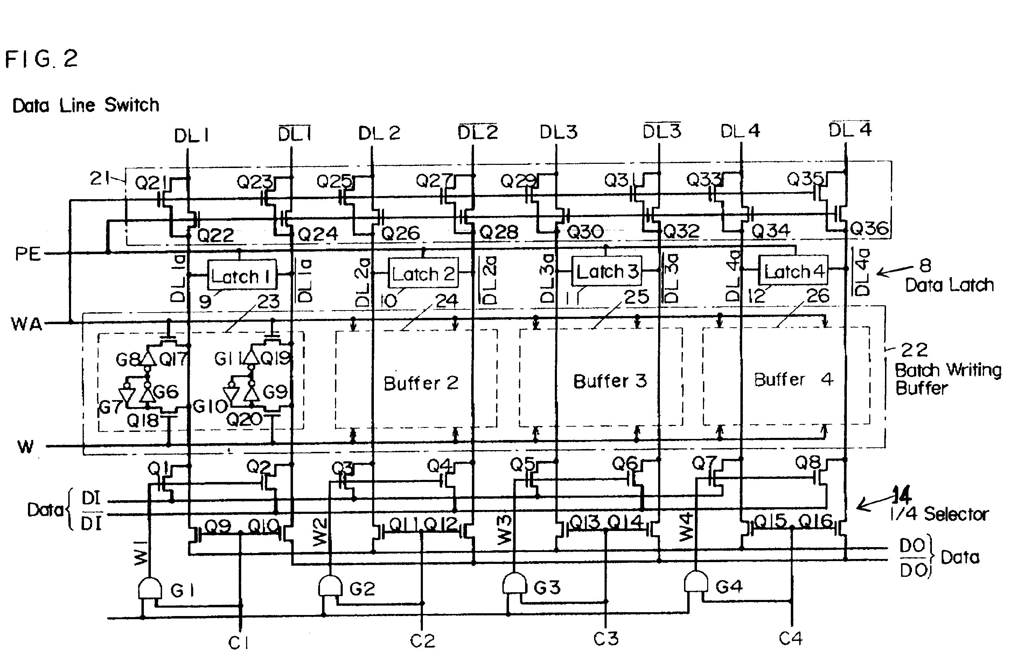

Fig. 2 is a detailed circuit diagram of principal parts of Fig. 1;

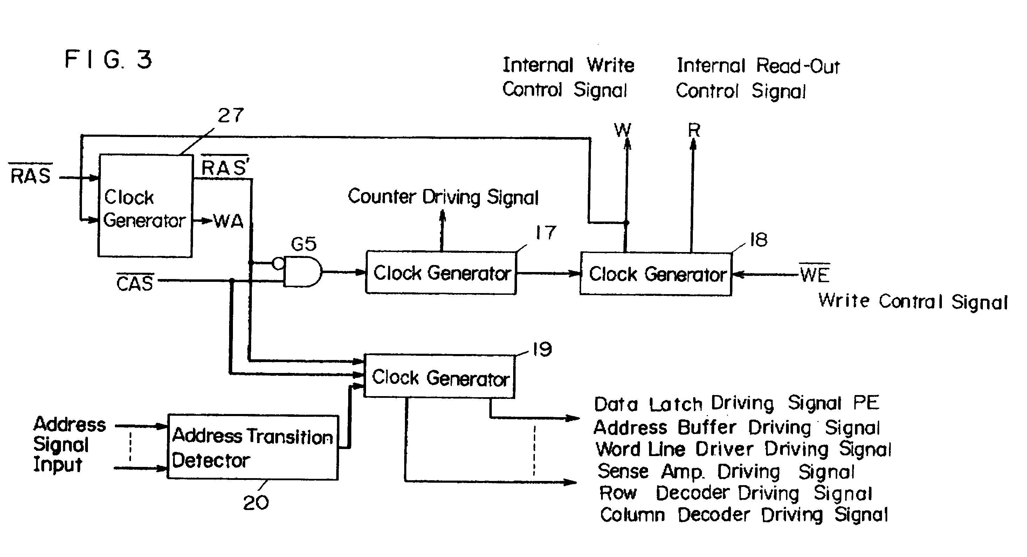

Fig. 3 is a block diagram of an internal clock signal generating circuit for generating driving signals of circuit blocks shown in Fig. 1;

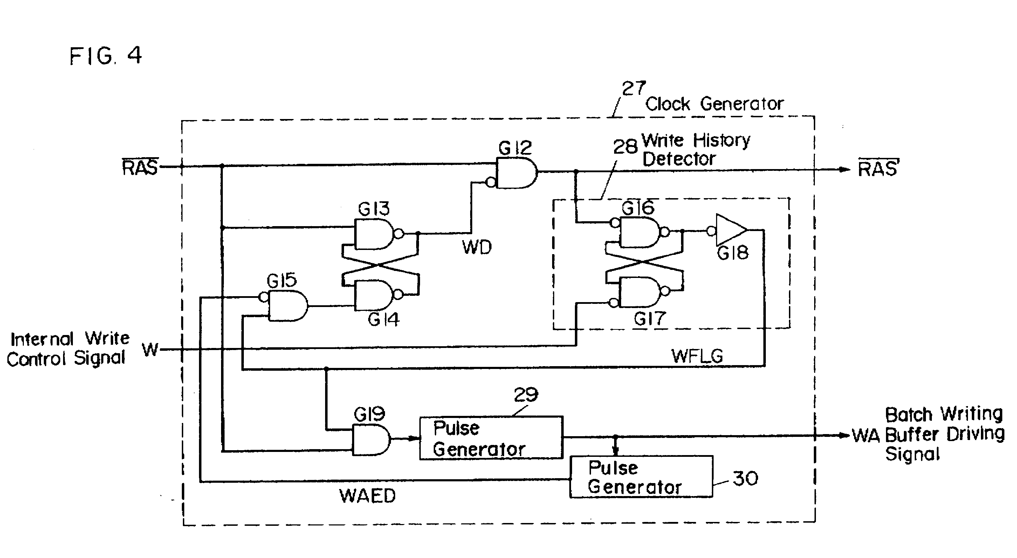

Fig. 4 is a detailed circuit diagram of the clock generator shown in Fig. 3;

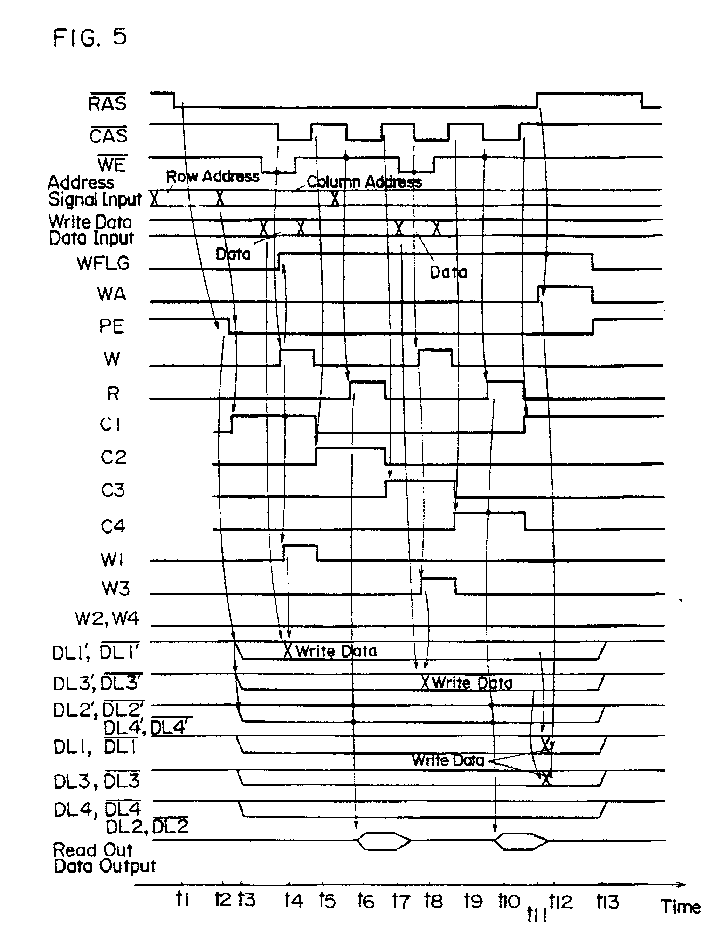

Fig. 5 shows voltage waveform diagrams of each node in Fig. 1;

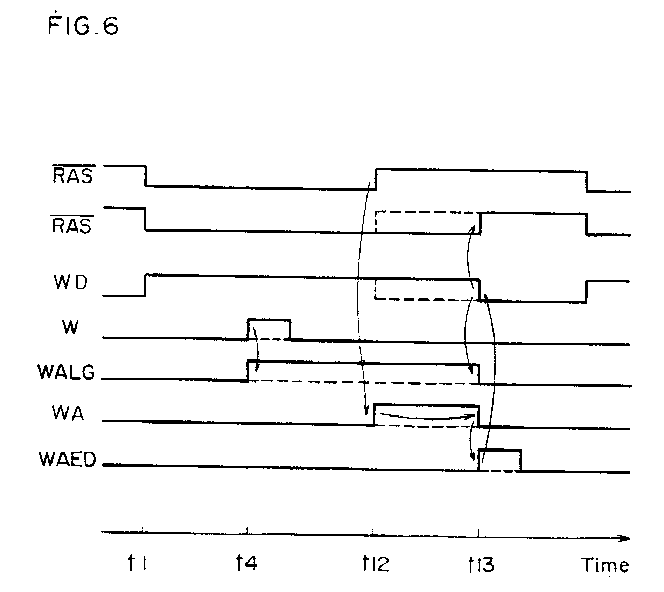

Fig. 6 shows voltage waveform diagrams of each node in Fig. 1;

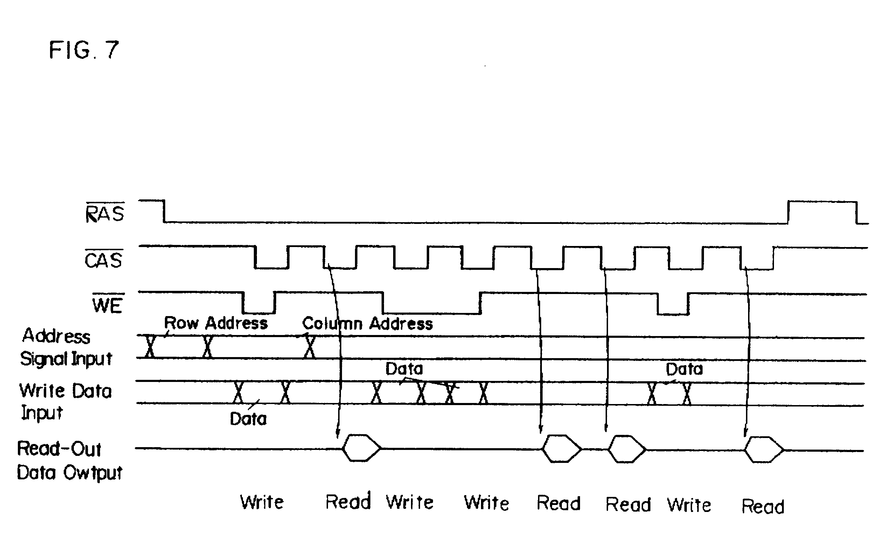

Fig. 7 shows voltage waveform diagrams explaining the operation of other embodiment of the invention;
Fig. 8 is a block diagram of data reading and writing circuits of a conventional semiconductor memory device;
Fig. 9 is a detailed circuit diagram of principal parts of Fig. 8;
Fig. 10 is a block diagram of an internal clock signal generating circuit for generating driving signals of circuit blocks shown in Fig. 8; and
Fig. 11 shows voltage waveform diagrams of each node in Fig. 8

### DETAILED DESCRIPTION OF THE INVENTION

Referring now to the drawings, the first embodiment of the invention is described below in detail. Same as in the prior art, the first embodiment is also represented by an example of DRAM increased in speed by the nibble mode function.

Fig. 1 is a block diagram of data reading and writing circuits of a semiconductor memory device in the first embodiment of the invention which is designed to raise the speed by the nibble mode function.

In Fig. 1, row address buffer 1, column address buffer 2, row decoder 3, word line driver 4, memory cell array 5, sense amplifier 6, column decoder 7, data latch 8, latch circuits 9 to 12 for composing it, data input buffer 13, selector 14, data output buffer 15, and counter 16 are identical with corresponding circuits in Fig. 8. What is different between the circuit composition in Fig. 1 and the prior art in Fig. 8 is as follows: (1) a data line switch 21 is provided in;order to temporarily separate the data lines of four pairs connected to the data latch 8, from the data lines connected to the sense amplifier 6 or bit lines connected to the memory cell array 5, and (2) a batch writing buffer 22 is provided, aside from the data latch 8, on the data lines separated by the data line switch 21. The batch writing buffer 22 is driven by the batch writing buffer driving signal (internal clock signal) WA, and the data line switch 21 is driven by the data latch driving signal PE and batch writing buffer driving signal WA.

Fig. 2 shows a detailed circuit composition comprising the data latch 8, selector 14, and newly added data line switch 21 and batch writing buffer 22 shown in Fig. 1. As understood from Fig. 2, the data latch 8 and the selector 14 are same as the conventional circuit composition in Fig. 9. In Fig. 2, DL1, D̅L̅1̅ to DL4, D̅L̅4̅ are four pairs of data lines connected to the column decoder 7, sense amplifier 6 and others. Meanwhile, DL1a, D̅L̅1̅a̅ to DL4a, D̅L̅4̅a̅ are data lines separated by the data line switch 21, to which the data latch 8 and batch writing buffer 22 are connected. The data line switch 21 is composed of MIS transistors Q21 to Q36, and the data lines are separated when the data latch driving signal PE is at low level (active state), and the batch writing buffer driving signal WA is at low level (inactive state). The batch writing buffer 22 is composed of buffers 23 to 26 connected to data lines. Each one of the buffers 23 to 26 is composed of inverters G6 to G11 and transistors Q17 to Q20 (in Fig. 2, for the sake of simplicity, only the buffer 23 is described in detail, and the detailed circuits of buffers 24 to 26 are omitted). This batch writing buffer 22, when the internal write control signal W is at high level (active state), latches the data on the data lines to which the buffers 23 to 26 are connected, in the buffers 23 to 27, on the data lines DL1a, D̅L̅1̅a̅ to DL4a, D̅L̅4̅a̅, and when the batch writing buffer driving signal WA is at high level (active state), it functions as the buffer to drive the data lines at low impedance. The structure of the internal clock signal generating circuit for driving the circuits in Fig. 1 and Fig. 2 is shown in Fig. 3 and Fig. 4. In Fig. 3 and Fig. 4, clock generators 17 to 19, address transition detector 20, logic gate G5, R̅A̅S̅, C̅A̅S̅, W̅E̅ and address signal input are all signals applied from outside of the memory device, and are identical with the composition of the prior art shown in Fig. 10. The clock generator 27 in Fig. 3 is newly added in this embodiment, and it is intended to generate the batch writing buffer driving signal WA in Fig. 1 and Fig. 2. Fig. 4 shows a further detailed circuit composition of the clock generator 27. As shown in Fig. 4, the clock generator 27 is composed of logic gates G12 to G19, and pulse generators 29, 30, and a write history detector 28 is composed of logic gates G16 to G18.

In thus composed DRAM, the operation in its nibble mode is explained below while referring to the circuit diagrams in Figs. 1, 2, 3, and the timing charts in Figs. 5, 6.

In Fig. 5, same as in the description of the prior art, the C̅A̅S̅ input is made four times in the R̅A̅S̅ active period, and the first time and third time are data writing, and the second and fourth time are data reading. Besides, of the clock signals for driving the circuits in Fig. 1, Fig. 2, the action of the signals having the common name as in the prior art are same as in the prior art, except for the data latch driving signal PE, and the operation in data reading is also same as in the prior art. Therefore, herein, the operation of data writing which is largely different from the prior art is mainly described.

At time t1, when the first reference clock R̅A̅S̅ becomes low level to be in active state, the write control signal W̅E̅ is set in low level, and the first C̅A̅S̅ input is generated at time t4, and the data is written. At this time, since both data latch driving signal PE and write control signal W̅E̅ are at low level, the data line switch 21 in Fig. 1, Fig. 2 is cut off, and the data lines DL1, D̅L̅1̅ and DL1a, D̅L̅1̅a̅ are separated. Accordingly, write data is transferred only to DL1a, D̅L̅1̅a̅. At this time, since the internal write control signal W becomes high level (active state), in the batch writing buffer 22 in Fig. 1, Fig. 2, the data on the data lines (DL1a, D̅L̅1̅a̅ to DL4a, D̅L̅4̅a̅) to which buffers 23 to 26 are connected are latched in the buffers 23 to 24. In the buffer 23 on the data lines D̅L̅1̅a̅, D̅L̅1̅a̅ in which data are written, the write data is directly latched, and in the other buffers 24 to 26, the read data being latched at time t3 are latched. In consequence, the write history detection circuit 28 in Fig. 4 is actuated, and the write history detection signal WFLG becomes high level. Writing of data into the data lines DL3a, D̅L̅3̅a̅ to be done at the time of the third C̅A̅S̅ input (time t8) is conducted similarly, and at this time, the write data is latched in the buffer 25 in Fig. 5. In this way, when all C̅A̅S̅ cycles are over, at time t12, R̅A̅S̅ becomes high level to be in inactive state. Here, since the data write action is done one or more times during the active period of R̅A̅S̅, the output signal WFLG Of the write history detector 28 is at high level. Thereby, the logic gate G19 and pulse generator 29 in Fig. 4 are actuated, and in synchronism with the rise of R̅A̅S̅, the batch writing buffer driving signal WA is activated to be in high level. When the batch writing buffer driving signal WA is set in active state, the data line switch 21 in Fig. 1, Fig. 2 is set in conductive state, and the hitherto separated data lines are coupled with the memory cell array 5 which is the final target of data writing by way of the column decoder 7, sense amplifier 6, etc. Moreover, since the batch writing buffer 22 possesses a function as a buffer to drive the data lines at low impedance, writing of data into the memory cell in the memory cell array 5 is realized here for the first time. Consequently, after passing necessary time for writing data generated by the clock generator 27 in Fig. 4, all action is completed at time t13 (Fig. 5, Fig. 6).

Thus, according to this embodiment, in the circuit for realizing the nibble mode of DRAM, the data line switch 21 for data line separation, and the batch writing buffer 22 for temporarily latching the write data transferred to the data lines at the time of data writing in every C̅A̅S̅ cycle and operating as the buffer for batch transfer to the data to the selected memory cells are disposed on data lines, and furthermore the write history detector for detecting and storing the data write cycles within a series of C̅A̅S̅ cycles, and the circuit for driving the data batch writing buffer in synchronism with the inactivation of the R̅A̅S̅ clock on the basis of the result of its detection are also provided. By thus composing, as compared with the system of writing data up to the memory cells at every C̅A̅S̅ cycle of the nibble mode in the conventional circuit, the writing time in every C̅A̅S̅ cycle is markedly shortened, and the total writing time is shortened by batch writing of data into memory cells.

In the foregoing embodiment of the invention, incidentally, an example of nibble mode of DRAM is illustrated, but, needless to say, the invention may be equally applied to other similar high speed modes, such as byte mode or serial mode.

Fig. 7 shows voltage waveforms of principal nodes in the byte mode.

The basic composition of the byte mode is similar to that of the first embodiment, and its operation is same as in the first embodiment, in principle. What is different is that the byte mode handles data in 8-bit units, while the nibble mode handles data in 4-bit units. Therefore, as shown in Fig. 7, C̅A̅S̅ is entered 8 times within the active period of RAS. In Fig. 7, data is written by the 1st, 3rd, 4th and 7th C̅A̅S̅ inputs, and the data is read out by the 2nd, 5th, 6th and 8th inputs.

When applying the invention in such byte-mode semiconductor memory device, eight latch circuits corresponding to eight bits are provided as the data latch 8 shown in Fig. 1, Fig. 2.

On the other hand, the serial mode (also known as extended nibble mode), is basically similar in composition and operation to the nibble mode of the first embodiment. Exceptionally, while the nibble mode handles data in 4-bit unit, the serial model handles data in the row unit of the memory address space, generally (for example, 64 bits, 256 bits, 1k bite, 2k bits, etc.). Therefore, as the data latch 8 shown in Fig. 1, Fig. 2, the latch circuits are provided as many as the number corresponding to the row unit in the memory address space (in the examples above, 64, 256, 1000, 2000, etc.).

Although the timing chart of the serial mode is not shown, there are 64, 256 or other C̅A̅S̅ inputs within the active peirod of R̅A̅S̅ in Fig. 7, and the data is written and read out in synchronism with each C̅A̅S̅ input.

## Claims

1. A semiconductor memory device comprising:
means for providing a first reference clock signal (R̅A̅S̅) and a second reference clock signal (C̅A̅S̅);
a memory cell array (5) having plural memory cells disposed in an array;
selecting means (3,4,7) for selecting a plurality of memory cells from among said plural memory cells of said memory cell array;
a plurality of data lines (DL1, D̅L̅1̅, ..., DL4, D̅L̅4̅) coupled to said selecting means, each of said plurality of data lines for transmitting write data to and read data from said memory cell array; and
a read data latch means (8), having a plurality of latch circuits (9-12) respectively coupled to said plurality of data lines, for temporarily storing read data therein,
characterised in that the device further comprises a write data latch means (22), having a plurality of buffer circuits respectively coupled to said plurality of data lines, for temporarily storing write data therein in response to a write control signal (W) and in synchronism with the second reference clock signal, during the active period of the first reference signal; and
write history storing means (28) for storing the write history when write data is stored into said write data latch means during the active period of said first reference clock signal;
wherein write data is written in batch into the selected memory cell according to the result of said write history during the inactive period of said first reference clock signal, if there is write history in said write data latch means.

2. A semiconductor memory device as recited in claim 1, further comprising means (14,15) for sequentially reading the read data stored in said read data latch means (8).

3. A semiconductor memory device as recited in claim 1 or 2, further comprising means for generating the write control signal responsive to the write history information stored in said write history storing means (28), wherein the batch operation is carried out responsive to the write control signal.

4. A semiconductor memory device as recited in claims 1, 2 or 3, wherein said write history storing means includes a single stage of latch circuits (G16, G17).

5. A semiconductor memory device as recited in any of the preceding claims, further comprising a selector circuit (14) coupled to said plurality of data lines.

6. A semiconductor memory device as recited in any of the preceding claims, further comprising means for transmitting data from each of said plurality of latch circuits (9,10,11,12) of said read data latch means (8) to an associated one of said plurality of buffer circuits (23,24,25,26) of said write data latch means (22) in which corresponding data have not been stored.

7. A semiconductor memory device according to any of the preceding claims, wherein the read data latch means (8) has four latch circuits (9,10,11,12) and the write data latch means (22) has four buffer circuits (23,24,25,26).

8. A semiconductor memory device according to any of claims 1 to 6, wherein the read data latch means (8) has eight latch circuits and the write data latch means (22) has eight buffer circuits.

9. A semiconductor memory device according to any of claims 1 to 6, wherein the read data latch means (8) has a specified number of latch circuits and the write data latch means (22) has the same specified number of buffer circuits, said specified number corresponding to the number of bits in a row unit of a memory address space of said memory cell array (5).

## Patentansprüche

1. Halbleiter-Speichereinrichtung, die umfaßt:
eine Einrichtung, die ein erstes Bezugstaktsignal R̅A̅S̅ und zweites Bezugstaktsignal C̅A̅S̅ erzeugt;
eine Speicherzellenanordnung (5) mit einer Vielzahl von Speicherzellen, die in einer Matrix angeordnet sind;
eine Auswahleinrichtung (3, 4, 7), die eine Mehrzahl von Speicherzellen aus der Vielzahl von Speicherzellen der Speicherzellenanordnung auswählt;
eine Mehrzahl von Datenleitungen (DL1, D̅L̅1̅,..., DL4, D̅L̅4̅) die mit der Auswahleinrichtung verbunden sind, wobei jede der Mehrzahl von Datenleitungen Schreibdaten an die und Lesedaten von der Spelcherzellenanordnung überträgt, und
eine Lesedaten-Latcheinrichtung (8) mit einer Mehrzahl von Latchkreisen (9 - 12), die jeweils mit der Mehrzahl von Datenleitungen verbunden sind und Lesedaten vorübergehend darin speichern,
dadurch gekennzeichnet, daß die Einrichtung weiter eine Schreibdaten-Latcheinrichtung (22) mit einer Mehrzahl von Pufferschaltungen umfaßt, die jeweils mit der Mehrzahl von Datenleitungen verbunden sind und als Reaktion auf ein Schreibsteuersignal (W) und synchron mit dem zweiten Bezugstaktsignal während der aktiven Periode des ersten Bezugstaktsignals Schreibdaten vorübergehend darin speichern, und
eine Schreibvergangenheits-Speichereinrichtung (28), die die Schreibvergangenheit speichert, wenn während der aktiven Periode des ersten Bezugstaktsignals Schreibdaten in die Schreibdaten-Latcheinrichtung geschrieben werden,
wobei die Schreibdaten nach Maßgabe des Ergebnisses der Schreibvergangenheit während der inaktiven Periode des ersten Bezugstaktsignals stapelweise in die ausgewählte Speicherzelle geschrieben werden, wenn in der Schreibdaten-Latcheinrichtung eine Schreibvergangenheit vorhanden ist.

2. Halbleiter-Speichereinrichtung nach Anspruch 1, die weiter eine Einrichtung (14, 15) umfaßt, die die in der Lesedaten-Latcheinrichtung (8) gespeicherten Lesedaten sequentiell liest.

3. Halbleiter-Speichereinrichtung nach Anspruch 1 oder 2, die weiter eine Einrichtung umfaßt, die das Schreibsteuersignal als Reaktion auf die in der Schreibvergangenheits-Speichereinrichtung (28) gespeicherte Schreibvergangenheitsinformation erzeugt, wobei die Stapeloperation als Reaktion auf das Schreibsteuersignal durchgeführt wird.

4. Halbleiter-Speichereinrichtung nach Anspruch 1, 2 oder 3, bei der die Schreibvergangenheits-Speichereinrichtung eine einzige Stufe von Latchkreisen (G16, G17) umfaßt.

5. Halbleiter-Speichereinrichtung nach einem der vorangehenden Ansprüche, die weiter eine mit der Mehrzahl von Datenleitungen verbundene Auswahleinrichtung (14) umfaßt.

6. Halbleiter-Speichereinrichtung nach einem der vorangehenden Ansprüche, die weiter eine Einrichtung umfaßt, die Daten von jedem der Mehrzahl von Latchkreisen (9, 10, 11, 12) der Lesedaten-Latcheinrichtung (8) an eine zugehörige der Mehrzahl von Pufferschaltungen (23, 24, 25, 26) der Schreibdaten-Latcheinrichtung (22) sendet, in der keine entsprechenden Daten gespeichert worden sind.

7. Halbleiter-Speichereinrichtung nach einem der vorangehenden Ansprüche, bei der die Lesedaten-Latcheinrichtung (8) vier Latchkreise 9, 10, 11, 12) und die Schreibdaten-Latcheinrichtung (22) vier Pufferschaltungen (23, 24, 25, 26) besitzen.

8. Halbleiter-Speichereinrichtung nach einem der Ansprüche 1 bis 6, bei der die Lesedaten-Latcheinrichtung (8) acht Latchkreise und die Schreibdaten-Latcheinrichtung (22) acht Pufferschaltungen besitzen.

9. Halbleiter-Speichereinrichtung nach einem der Ansprüche 1 bis 6, bei der die Lesedaten-Latcheinrichtung (8) eine spezifizierte Zahl von Latchkreisen besitzt und die Schreibdaten-Latcheinrichtung (22) dieselbe spezifizierte Zahl von Pufferschaltungen besitzt, wobei die spezifizierte Zahl der Zahl von Bits in einer Reiheneinheit eines Speicheradressenraumes der Speicherzellenanordnung (5) entspricht.

## Revendications

1. Dispositif de mémorisation à semiconducteur, comprenant:
un moyen servant à produire un premier signal d'horloge de référence (R̅A̅S̅) et un deuxième signal d'horloge de référence (C̅A̅S̅);
une matrice (5) de cellules de mémoire possédant plusieurs cellules de mémoire qui sont disposées suivant une matrice ;
un moyen de sélection (3, 4, 7) servant à sélectionner une pluralité de cellules de mémoire parmi lesdites cellules de mémoire de ladite matrice de cellules de mémoire ;
une pluralité de lignes de données (DL1, DL1,... DL4, D̅L̅4̅) couplées audit moyen de sélection, chaque ligne de ladite pluralité de lignes de données étant destinée à transmettre des données d'écriture à destination de ladite matrice de cellules de mémoire et des données de lecture en provenance de ladite matrice de cellules de mémoire;
un moyen (8) de verrouillage de données de lecture, possédant une pluralité de circuits de verrouillage (9 à 12) respectivement couplés à ladite pluralité de lignes de données, afin d'y enregistrer temporairement des données de lecture,
le dispositif étant caractérisé en ce qu'il comprend en outre un moyen (22) de verrouillage de données d'écriture, possédant une pluralité de circuits tampons respectivement couplés à ladite pluralité de lignes de données, afin d'y enregistrer temporairement des données d'écriture en réponse à un signal de commande d'écriture (w) et en synchronisme avec le deuxième signal d'horloge de référence, pendant la période active du premier signal d'horloge de référence ; et
un moyen (28) d'enregistrement d'historique d'écriture servant à enregistrer l'historique d'écriture lorsque des données d'écriture sont enregistrées dans ledit moyen de verrouillage de données d'écriture pendant la période active dudit premier signal d'horloge de référence ;
où les données d'écriture sont écrites, par lots, dans la cellule de mémoire sélectionnée en fonction du résultat dudit historique d'écriture pendant la période non active dudit premier signal d'horloge de référence, s'il existe un historique d'écriture dans ledit moyen de verrouillage de données d'écriture.

2. Dispositif de mémorisation à semiconducteur selon la revendication 1, comprenant en outre un moyen (14, 15) servant à lire séquentiellement les données de lecture enregistrées dans ledit moyen de verrouillage de données de lecture (8).

3. Dispositif de mémorisation à semiconducteur selon la revendication 1 ou 2, comprenant en outre un moyen qui produit le signal de commande d'écriture en réponse à l'information d'historique d'écriture enregistrée dans ledit moyen d'enregistrement d'historique d'écriture (28), où le fonctionnement par lots s'effectue en réponse au signal de commande d'écriture.

4. Dispositif de mémorisation à semiconducteur selon l'une quelconque des revendications 1, 2 et 3, où ledit moyen d'enregistrement d'historique d'écriture comporte un unique étage de circuits de verrouillage (G16, G17).

5. Dispositif de mémorisation à semiconducteur selon l'une quelconque des revendications précédentes, comprenant en outre un circuit sélecteur (14) couplé à ladite pluralité de lignes de données.

6. Dispositif de mémorisation à semiconducteur selon l'une quelconque des revendications précédentes, comprenant en outre un moyen qui sert à transmettre des données, en provenance de chaque circuit de ladite pluralité de circuits de verrouillage (9, 10, 11, 12) dudit moyen de verrouillage de données de lecture (8), à un circuit associé de ladite pluralité de circuits tampons (23, 24, 25, 26) dudit moyen de verrouillage de données d'écriture (22) dans lequel les données correspondantes n'ont pas été enregistrées.

7. Dispositif de mémorisation à semiconducteur selon l'une quelconque des revendications précédentes, où le moyen de verrouillage de données de lecture (8) possède quatre circuits de verrouillage (9, 10, 11, 12) et le moyen de verrouillage de données d'écriture (22) possède quatre circuits tampons (23, 24, 25, 26).

8. Dispositif de mémorisation à semiconducteur selon l'une quelconque des revendications 1 à 6, où le moyen de verrouillage de données de lecture (8) possède huit circuits de verrouillage et le moyen de verrouillage de données d'écriture (22) possède huit circuits tampons.

9. Dispositif de mémorisation à semiconducteur selon l'une quelconque des revendications 1 à 6, où le moyen de verrouillage de données de lecture (8) possède un nombre spécifié de circuits de verrouillage et le moyen de verrouillage de données d'écriture (22) possède le même nombre spécifié de circuits tampons, ledit nombre spécifié correspondant au nombre de bits présents dans une unité de rangée d'un espace d'adresse de mémoire de ladite matrice de cellules de mémoire (5).
